# EUROPÄISCHE PATENTSCHRIFT

(11) **EP 0 936 673 B1**
(45) Veröffentlichungstag und Bekanntmachung des Hinweises auf die Patenterteilung: **20.03.2002**
(21) Anmeldenummer: 98123065.9
(22) Anmeldetag: 09.12.1998
(51) Int. Cl.: H01L 27/108, H01L 27/115, H01L 29/78, H01L 21/8242

(54) **Speicherzellenanordnung und entsprechendes Herstellungsverfahren**
Memory cell array and corresponding manufacturing process
Réseau de cellules de mémoire et procédé de fabrication

(30) Priorität: 12.02.1998 DE 19805712
(43) Veröffentlichungstag der Anmeldung: 18.08.1999
(73) Patentinhaber: Infineon Technologies AG, 81669 München (DE)
(72) Erfinder: Böhm, Thomas, 85604 Zorneding (DE); Otani, Yoichi, Dr., 01478 Weixdorf (DE); Schlösser, Till, Dr., 81825 München (DE); Weinrich, Volker, Dr., 81373 München (DE); Rusch, Andreas, 01099 Dresden (DE); Trüby, Alexander, 01099 Dresden (DE); Hain, Manfred, 85591 Vaterstetten (DE); Zimmermann, Ulrich, Dr., Mechanicsville, VA 23116 (US); Kohlhase, Armin, Dr., 85579 Neubiberg (DE)
(74) Vertreter: Reinhard - Skuhra - Weise & Partner

(56) Entgegenhaltungen:
- EP-A- 0 744 771
- DE-C- 19 514 834
- DE-C- 19 637 389
- US-A- 5 497 017

## Beschreibung

Die vorliegende Erfindung betrifft eine Speicherzellenanordnung mit einer Vielzahl von in einem Halbleitersubstrat vorgesehenen vorzugsweise ferroelektrischen Speicherzellen (ferroelektrischer Speicher (FeRAM) bzw. nichtflüchtiger Speicher mit wahlfreiem Zugriff (NVRAM)) und ein entsprechendes Herstellungsverfahren.

Obwohl auf Speicher aus einem beliebigen Grundmaterial anwendbar, werden die vorliegende Erfindung sowie die ihr zugrundeliegende Problematik in bezug auf einen Speicher auf Siliziumbasis erläutert.

Allgemein besteht ein DRAM-Speicher aus einer Speicherzellenanordnung, deren einzelne Speicherzellen einen Auswahltransistor und einen damit verbundenen Kondensator aufweisen. Ein ROM-Speicher hat als Speicherzelle einfach nur einen Transistor.

Zunächst basierten die Speicherzellenanordnungen auf überwiegend planaren Konzepten. Unter der Vorgabe einer ständig größer werdenden Packungsdichte ist es nunmehr bereits für MaskROM-Anwendungen (Festwertspeicher) vorgeschlagen worden, die Zellfläche des Speichers durch das Einbringen paralleler Längsgräben zu falten und somit die Projektion der Zellfläche auf die Waferoberfläche um bis zu 50% zu reduzieren. Bei DRAMs ist die Ausnutzung der vertikalen Richtung in Form von Kapazitäten als Trench- oder Stacked-Kondensator bekannt.

Aus der US-A-5,497,017 ist ein DRAM-Speicher mit einem Kreuzungspunkt-Layout bekannt, wobei eine jeweilige Speicherzelle am Kreuzungspunkt einer Bitleitung und einer Wortleitung liegt. Jede Speicherzelle hat einen vertikalen Transistor, welcher in entsprechenden Gräben gebildet ist.

Aus der EP-A 0 744 771 Al ist eine DRAM-Speicherzelle mit einem vertikalen Transistor bekannt. Jede DRAM-Speicherzelle umfaßt einen vertikalen MOS-Transistor, dessen erstes Source/Drain-Gebiet mit einem Speicherknoten eines Speicherkondensators verbunden ist, dessen Kanalgebiet ringförmig von einer Gate-Elektrode umschlossen wird und dessen zweites Source/Drain-Gebiet mit einer vergrabenen Bitleitung verbunden ist.

Aus der DE 195 14 834 ist eine Festwertspeicherzellanordnung bekannt, die erste Speicherzellen mit einem vertikalen MOS-Transistor und zweite Speicherzellen ohne einen vertikalen MOS-Transistor aufweist. Die Speicherzellen sind entlang gegenüberliegenden Flanken von streifenförmigen, parallel verlaufenden Isolationsgräben angeordnet. Werden Breite und Abstand der Isolationsgräben gleich groß gewählt, so ist der minimale Platzbedarf pro Speicherzelle theoretisch 2F², wobei F die minimale Strukturgröße der Technologie ist.

Die DE 195 10 042 offenbart eine Festwertspeicherzellanordnung, bei der die Speicherzellen in parallel verlaufenden Zeilen angeordnet sind, wobei Längsgräben vorgesehen sind, die im Wesentlichen parallel zu den Zeilen verlaufen. Die Zeilen sind dabei jeweils abwechselnd auf der Hauptfläche zwischen benachbarten Längsgräben und auf dem Boden der Längsgräben angeordnet. Isolationsstrukturen sind zu gegenseitigen Isolation der Speicherzellen, die jeweils einen MOS-Transistor umfassen, vorgesehen. Quer zu den Zeilen verlaufen Wortleitungen, die jeweils mit den Gateelektroden von entlang unterschiedlichen Zeilen angeordneten MOS-Transistoren verbunden sind. Hierbei ist der minimale Platzbedarf pro Speicherzelle theoretisch 4 F², wobei F die minimale Strukturgröße der Technologie ist.

Aus der DE 195 43 539 ist eine RAM-Speicherzellenanordnung mit einem vertikalen Speicherkondensator mit einem ferroelektrischen oder paraelektrischen Speicherdielektrikum bekannt. Zur Herstellung des Speicherkondensators wird großflächig eine dielektrische Schicht für das Speicherdielektrikum erzeugt. Anschließend wird die dielektrische Schicht strukturiert, und es werden erste und zweite Elektroden für die Speicherkondensatoren gebildet.

Gemäß der DE 195 43 539 wird als Speicherdielektrikum ferroelektrisches Material für nichtflüchtige Speicher verwendet, da dieses eine spontane Polarisation aufweist, die auch ohne externes elektrisches Feld vorhanden ist. Para-elektrisches Material hingegen wird bei DRAM-Anwendungen verwendet, bei denen ein Auffrischungszyklus vorgesehen ist.

In der Praxis lassen sich mit den bekannten Konzepten für Speicherzellen bestehend aus einem Auswahltransistor und einer Speicherkapazität (z.B. DRAM) momentan allerdings nur Zellgrößen für eine Speicherzelle von 9,6 F² erzielen. Das Ziel ist eine Zellgröße von 8 F² ab der 1 Gb-Generation mit F = 0,18 µm.

Die der vorliegenden Erfindung zugrundeliegende Aufgabe besteht allgemein darin, eine einfach und zuverlässig herstellbare Speicherzellenanordnung mit vorzugsweise ferroelektrischen Speicherzellen sowie ein entsprechendes Herstellungsverfahren anzugeben.

Erfindungsgemäß wird diese Aufgabe durch die in Anspruch 1 angegebene Speicherzellenanordnung mit ferroelektrischen Speicherzellen sowie das in Anspruch 15 angegebene Herstellungsverfahren gelöst.

Die erfindungsgemäße Speicherzellenanordnung mit ferroelektrischen Speicherzellen weist gegenüber den bekannten Speicherzellenanordnungen den Vorteil auf, daß sie eine erreichbare minimale Zellgröße von 6 F² aufweist.

Im Gegensatz zum üblichen Verfahren zur Herstellung eines DRAM mit Stacked-Kondensator liegt die Bitleitung bei der erfindungsgemäßen Speicherzellenanordnung nicht mehr zwischen Source/Drain-Gebiet und Kondensator. Deshalb ist das Aspektverhältnis für den Kontaktstöpsel, der für den Anschluß des Kondensators an den Auswahltransistor sorgt, deutlich entspannt. Zum Anschließen der Bitleitung wird dieselbe mit einem Diffusionskontakt auf die ursprüngliche Halbleitersubstrathöhe hochgeführt, so daß sich auch hier ein entspanntes Aspektverhältnis für die Kontaktlöcher ergibt. Die Kontaktstöpsel sind self-aligned bzw. selbstausgerichtet ausführbar. Ansonsten kann ebenfalls ausschließlich auf übliche Prozeßschritte zurückgegriffen werden.

Die der vorliegenden Erfindung zugrundeliegende Idee besteht darin, daß der Auswahltransistor als Vertikaltransistor an einer Grabenwand realisiert ist, wobei die gegenüberliegende Grabenwand derart gestaltet ist, daß der dort befindliche Transistor immer geschlossen ist, d.h. seine Einsatzspannung jenseits der Versorgungsspannung liegt. Die planare Grundfläche für die ferroelektrische Kapazität beträgt 2 F². Diese Größe ist bei dem angegebenen Herstellungsverfahren ohne technische Schwierigkeiten realisierbar. Eine weitere Vergrößerung der Kondensatorfläche kann durch Ausnutzung der Seitenflächen der unteren Elektrode erzielt werden.

In den jeweiligen Unteransprüchen finden sich vorteilhafte Weiterbildungen und Verbesserungen der in Anspruch 1 angegebenen Speicherzellenanordnung mit ferroelektrischen Speicherzellen bzw. des in Anspruch 15 angegebenen Herstellungsverfahrens.

Gemäß einer bevorzugten Weiterbildung ist das jeweilige Kanalgebiet an der dem Auswahltransistor gegenüberliegenden Wand so dotiert, daß der dort befindliche Transistor immer geschlossen ist, d.h. seine Einsatzspannung jenseits der Versorgungsspannung liegt. So läßt sich ein Auswahltransistor über die Kanaldotierung, also über die Definition der Einsatzspannung, definieren.

Gemäß einer weiteren bevorzugten Weiterbildung ist zwischen den Source/Drain-Gebieten und den Kanalgebieten einerseits und der jeweiligen Wortleitung andererseits eine Oxidschicht vorgesehen. So läßt sich eine gute elektrische Isolation der Wortleitungen gegenüber den Source/Drain-Gebieten und den Kanalgebieten erzielen.

Gemäß einer weiteren bevorzugten Weiterbildung weisen die Wortleitungen seitlich isolierende Spacer aus Siliziumoxid oder Siliziumnitrid auf.

Gemäß einer weiteren bevorzugten Weiterbildung weisen die Wortleitungen an ihrer Oberseite einen isolierenden Spacer aus Siliziumoxid oder Siliziumnitrid auf.

Gemäß einer weiteren bevorzugten Weiterbildung sind die Wortleitungen vollständig in eine Isolatorschicht, die vorzugsweise dotiertes Silikatglas aufweist, eingebettet. Diese Schicht ist vorteilhaft als Träger für die Zellkondensatoren. Sie kann auch eine Doppelschicht sein, von denen die obere beispielsweise ein undotiertes Oxid ist.

Gemäß einer weiteren bevorzugten Weiterbildung sind durch die Isolatorschicht Kontaktstöpsel geführt, welche jeweils einen Kontakt zu einem Source/Drain-Gebiet eines Auswahltransistors einer betreffenden Speicherzelle bilden. Wenn die Wortleitungen vollständig mit isolierendem Material gekapselt sind, so kann der Anschluß der Source/Drain-Gebiete auf den Grabenkronen durch einen selbstausgerichteten Polysilizium-Kontaktstöpsel-Prozeß erfolgen.

Gemäß einer weiteren bevorzugten Weiterbildung sind die Kontaktstöpsel auf den Kronen der Bitleitungsgräben im Bereich zwischen den Isolationsgräben und den Wortleitungen vorgesehen.

Gemäß einer weiteren bevorzugten Weiterbildung ist in Verbindung mit dem jeweiligen Kontaktstöpsel auf der Isolatorschicht eine entsprechende untere Kondensatorelektrode vorzugsweise mit einer zwischengesetzten Barrierenschicht vorgesehen.

Gemäß einer weiteren bevorzugten Weiterbildung ist über den unteren Kondensatorelektroden und der dazwischenliegenden Isolatorschicht großflächig eine Schicht aus einem Ferroelektrikum, vorzugsweise aus Strontium-Wismut-Tantalat, vorgesehen.

Gemäß einer weiteren bevorzugten Weiterbildung ist über der Schicht aus einem Ferroelektrikum großflächig eine gemeinsame obere Kondensatorelektrode vorgesehen. Dies schützt die gesamte Struktur von oben und erspart eine Strukturierung in eine Vielzahl oberer Kondensatorelektroden.

Gemäß einer weiteren bevorzugten Weiterbildung weisen die Gräben der Bitleitungen, die Kronen der Bitleitungen, die Wortleitungen und die Isolationsgräben jeweils eine minimale Strukturbreite F auf, beträgt der Bereich zwischen zwei Isolationsgräben 2 F und nimmt jede Speicherzelle einen Bereich von insgesamt 6 F² ein.

Gemäß einer weiteren bevorzugten Weiterbildung nimmt die jeweilige untere Kondensatorplatte einen Bereich von 2 F² ein.

Gemäß einer weiteren bevorzugten Weiterbildung ist die jeweilige untere Kondensatorplatte in Querrichtung im Bereich zwischen zwei benachbarten Bitleitungsgräben und in Längsrichtung im Bereich zwischen einer Wortleitung und einem benachbarten Isolationsgraben und die Wortleitung und den Isolationsgraben jeweils zur Hälfte überdeckend vorgesehen. So ist in jeder Richtung der Abstand F zur nächstbenachbarten unteren Kondensatorplatte realisierbar.

Ausführungsbeispiele der Erfindung sind in den Zeichnungen dargestellt und in der nachfolgenden Beschreibung näher erläutert.

Es zeigen:
- Fig. 1: eine Aufsicht auf ein Zellenfeld gemäß einer Ausführungsform der erfindungsgemäßen Speicherzellenanordnung;
- Fig. 2: eine vertikale Querschnittsansicht des Zellenfelds entlang der Linie A-A' von Fig. 1; und
- Fig. 3: eine vertikale Querschnittsansicht des Zellenfelds entlang der Linie B-B' von Fig. 1.

In den Figuren bezeichnen gleiche Bezugszeichen gleiche oder funktionsgleiche Bestandteile.

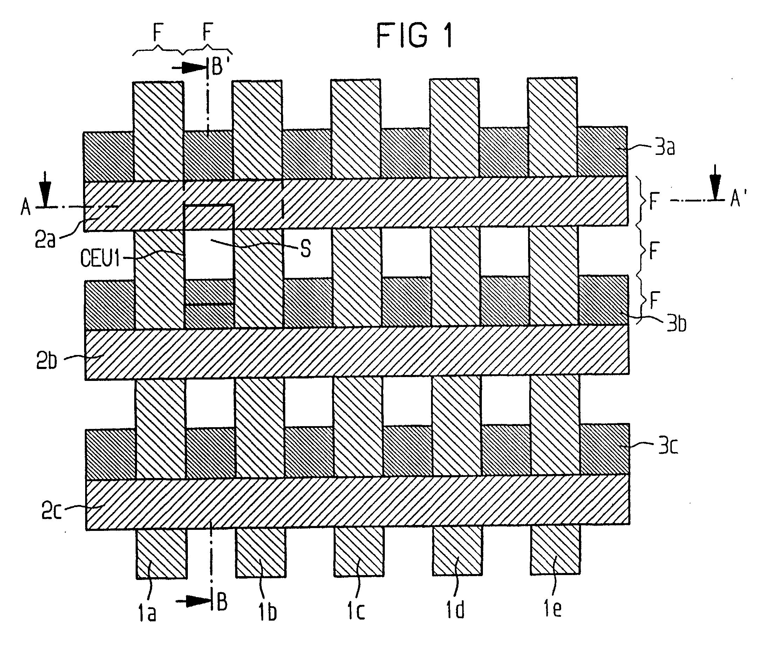

Fig. 1 ist eine Aufsicht auf ein Zellenfeld gemäß einer Ausführungsform der erfindungsgemäßen Speicherzellenanordnung.

In Fig. 1 bezeichnen 1a - 1e Bitleitungsgräben, 2a - 2d Wortleitungen, 3a - 3d Isolationsgräben (STI-Gräben), S eine einzelne Speicherzelle und F die minimale Strukturbreite. Weiterhin ist CEU1 die untere Kondensatorelektrode der Speicherzelle S.

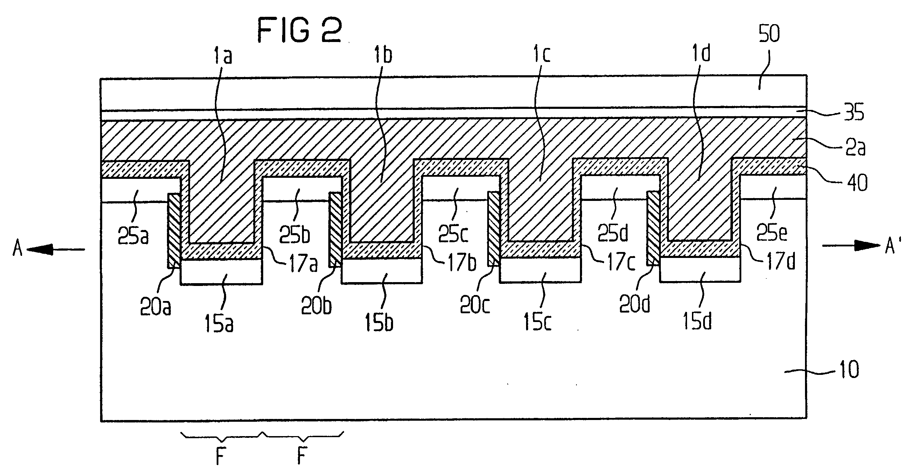

Gemäß der Darstellung von Fig. 1 weist das Zellenfeld eine Vielzahl von in einem Halbleitersubstrat 10 vorgesehenen ferroelektrischen Speicherzellen S auf. In Längsrichtung B-B' in der Hauptfläche des Halbleitersubstrats 10 verlaufen parallel zueinander Bitleitungsgräben 1a-1e, in deren Böden jeweils eine Bitleitung (15a-15d in Fig. 2) vorgesehen ist. In den Kronen der Bitleitungsgräben 1a-1e ist jeweils ein Source/Drain-Gebiet (25a-25d in Fig. 2) vorgesehen, und in den Wänden der Bitleitungsgräben 1a-1e ist jeweils ein Kanalgebiet (17a-17d; 20a-20d) vorgesehen.

In Querrichtung A-A' entlang der Hauptfläche des Halbleitersubstrats 10 durch die Bitleitungsgräben 1a-1e verlaufen isolierte Wortleitungen 2a-2d zur Ansteuerung der Auswahltransistoren der Speicherzellen S, deren Aufbau im Zusammenhang mit Fig. 2 näher erläutert wird. In Querrichtung A-A' in der Hauptfläche des Halbleitersubstrats 10 verlaufen außerdem Isolationsgräben 3a-3c zur Isolation der Source/Drain-Gebiete in Längsrichtung benachbarter Speicherzellen S.

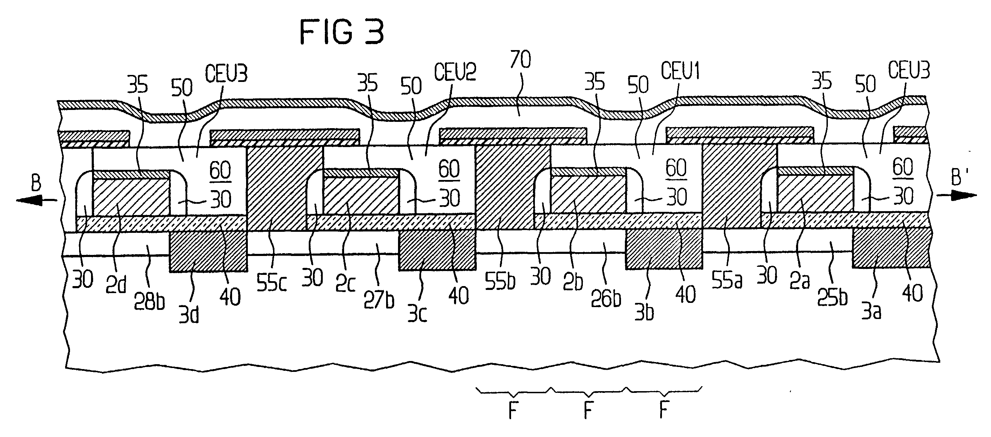

Jeder Speicherzelle S ist ein ferroelektrischer Kondensator (CEU1-CEU3; CEO; 70 in Fig. 3) zugeordnet, der mit dem Source/Drain-Gebiet (25b, 26b, 27b, 28b in Fig. 3) der betreffenden Speicherzelle S verbundenen ist und dessen Aufbau im Zusammenhang mit Fig. 3 näher erläutert wird.

Im folgenden werden die Dimensionsverhältnisse beim Zellenfeld gemäß dieser Ausführungsform der erfindungsgemäßen Speicherzellenanordnung näher erläutert.

Die Gräben der Bitleitungen 1a-1e, die Kronen der Bitleitungen 1a-1e, die Wortleitungen 2a-2d und die Isolationsgräben 3a-3d weisen jeweils eine minimale Strukturbreite F (< 0,2 µm) auf. Der Bereich zwischen zwei Isolationsgräben 3a-3d beträgt 2 F. Jede Speicherzelle S nimmt somit einen Bereich von 6 F² ein.

Weiterhin nimmt, wie gezeigt, die jeweilige untere Kondensatorplatte CEU1-CEU3 einen Bereich von 2 F² ein. Dabei ist die jeweilige untere Kondensatorplatte CEU1-CEU3 in Querrichtung im Bereich zwischen zwei benachbarten Bitleitungsgräben 1a, 1b und in Längsrichtung im Bereich zwischen einer Wortleitung 2a und einem benachbarten Isolationsgraben 3b und die Wortleitung 2a und den Isolationsgraben 3b jeweils zur Hälfte überdeckend vorgesehen.

Fig. 2 ist eine vertikale Querschnittsansicht des Zellenfelds entlang der Linie A-A' von Fig. 1.

In Fig. 2 bezeichnen 10 ein Halbleitersubstrat, 15a - 15d Bitleitungen, 17a - 17d offene Kanalgebiete, 20a - 20d geschlossene Kanalgebiete, 25a - 25e Source/Drain-Gebiete, 35 die obere Isolation der Wortleitung 40 ein Gateoxid und 50 einen Isolator (z.B. Borphosphorsilikatglas).

Wie aus Fig. 2 ersichtlich, ist jeweils das Kanalgebiet 17a-17d an einer Wand der Bitleitungsgräben 1a-1e derart gestaltet, daß dort ein ansteuerbarer Auswahltransistor der betreffenden Speicherzelle S gebildet ist (offenes Kanalgebiet). Hingegen ist das Kanalgebiet 20a-20d an der anderen Wand der Bitleitungsgräben 1a-1e derart gestaltet, daß der dortige Transistor nicht ansteuerbar ist, d.h. erst mit einer Spannung ansteuerbar ist, der jenseits der verwendeten Betriebsspannung bzw. Versorgungsspannung liegt (geschlos-senes Kanalgebiet). Zu diesem Zweck ist das jeweilige Kanalgebiet 20a-20d an der anderen Wand höher dotiert als das jeweilige Kanalgebiet 17a-17d an der einen Wand.

Zwischen den Source/Drain-Gebieten 25a-25d und den Kanalgebieten 17a-17d; 20a-20d einerseits und der jeweiligen Wortleitung 2a-2d andererseits ist eine Oxidschicht 40 vorgesehen.

Fig. 3 ist eine vertikale Querschnittsansicht des Zellenfelds entlang der Linie B-B' von Fig. 1.

In Fig. 3 bezeichnen CEU1 - CEU3 untere Kondensatorelektroden, CEO eine obere Kondensatorelektrode, 26b, 27b, 28b Source/Drain-Gebiete weiterer Speicherzellen, 30 eine seitliche Isolation der Wortleitungen (z.B. SiN), 60 eine Barrierenschicht (z.B. TiN), 55a - 55c Kontaktstöpsel (z.B. aus Polysilizium) sowie 70 eine ferroelektrische Schicht (z.B. Strontium-Wismut-Tantalat (SBT) o.ä.).

Wie Fig. 3 entnehmbar, weisen die Wortleitungen 2a-2d, die auf der Oxidschicht 40 verlaufen, seitlich isolierende Spacer 30 aus Siliziumnitrid auf. Weiterhin weisen die Wortleitungen 2a-2d an ihrer Oberseite einen isolierenden Spacer aus Siliziumoxid auf und sind somit vollständig gekapselt.

Alle Wortleitungen 2a-2d sind vollständig in eine Isolatorschicht 50 aus dotiertem Silikatglas, z.B. Phosphorsilikatglas, eingebettet. Durch die Isolatorschicht 50 sind Kontaktstöpsel 55a-55c aus Polysilizium geführt, welche jeweils einen Kontakt zu einem Source/Drain-Gebiet 25b, 26b, 27b eines Auswahltransistors einer betreffenden Speicherzelle bilden. Im Zusammenhang mit der Darstellung von Fig. 1 und 2 sind die Kontaktstöpsel 55a-55c auf den Kronen der Bitleitungsgräben 1a-1e im Bereich zwischen den Isolationsgräben 3a-3d und den Wortleitungen 2a-2d vorgesehen. In Verbindung mit einem jeweiligen Kontaktstöpsel 55a-55c ist auf der Isolatorschicht 50 eine entsprechende untere Kondensatorelektrode CEU1-CEU3 mit einer zwischengesetzten Barrierenschicht vorgesehen.

Über den unteren Kondensatorelektroden CEU1-CEU3 und der dazwischenliegenden Isolatorschicht 50 ist großflächig eine Schicht 70 aus einem Ferroelektrikum, hier aus Strontium-Wismut-Tantalat (SBT), vorgesehen. Über der Schicht 70 aus Strontium-Wismut-Tantalat (SBT) schließlich ist großflächig eine gemeinsame obere Kondensatorelektrode CEO vorgesehen.

Im folgenden wird das Herstellungsverfahren zur Herstellung des in Fig. 1 bis 3 illustrierten Zellenfeldes gemäß der Ausführungsform der erfindungsgemäßen Speicherzellenanordnung näher erläutert.

In der Hauptfläche des bereitgestellten Halbleitersubstrats 10 werden zunächst die Isolationsgräben 3a-3c in an sich bekannter STI-Technik gebildet. Es folgen das ebenfalls bekannte Bilden der Bitleitungsgräben 1a-1e in der Hauptfläche des Halbleitersubstrats 10 und das Bilden der Bitleitungen 15a-15d und der Source/Drain-Gebiete 25a-25d durch gleichzeitige Implantation.

Durch Ändern der Dotierung der jeweiligen (linken in Fig. 2) Wände 20a - 20e der Bitleitungsgräben 1a - 1e wird verhindert, daß dort wie bei den Wänden 17a - 17d Auswahltransistoren entstehen. Anschließend wird ein Gateoxid aufgewachsen (vgl. Fig. 2). Die Reihenfolge der Dotierung der Wände 20a - 20e und der Gateoxid-Erzeugung kann vertauscht werden. In diesem Fall wirkt das Gateoxid als Streuoxid.

Das nunmehr folgende Bilden der Wortleitungen 2a-2d umfaßt ein großflächiges Abscheiden einer Schicht aus Wortleitungsmaterial, hier Polysilizium. Darauf wird eine Hartmaske beispielsweise aus Oxid entsprechend der Wortleitungsstruktur vorgesehen. Danach erfolgt das Ätzen der Wortleitungen 2a-2d mit der Hartmaske durch einen an sich bekannten Prozeß. Die Hartmaske wird dann auf der Oberseite der Wortleitungen als jeweiliger oberer isolierender Spacer belassen. Es folgt das Bilden seitlicher isolierender Spacer 30 aus Siliziumnitrid, um so die Wortleitungen 2a-2d vollständig zu kapseln. Ein anschließendes Abscheiden und Planarisieren (z.B. mechanisches Polieren) einer Isolatorschicht 50 aus dotiertem Silikatglas bzw. einer Doppelschicht aus undotiertem Oxid oder Nitrid mit einem dotierten Silikatglas schafft eine ebene Oberfläche.

Als nächstes werden Durchgangslöcher in der Isolatorschicht 50 zur Kontaktierung der Source/Drain-Gebiete der jeweiligen Speicherzellen gebildet. Danach erfolgt das Abscheiden einer Schicht aus dem Kontaktstöpselmaterial, hier Polysilizium, und Rückätzen (Etch Back) der Schicht bis zur Isolatorschicht 50.

Nun kann der Prozeßkomplex zur Herstellung der Kondensatoren beginnen. Zunächst erfolgt das Abscheiden einer leitenden Barrierenschicht 60 z.B. aus TiN auf der Isolatorschicht 50 mit den Kontaktstöpseln 55a-55c. Anschließend wird eine Schicht aus dem Material der unteren Kondensatorelektroden CEU1-CEU3, hier Pt, auf der Barrierenschicht 60 abgeschieden.

Das nachfolgende Strukturieren der Barrierenschicht 60 und der Schicht aus dem Material der unteren Kondensatorelektroden CEU1-CEU3 zum Bilden der unteren Kondensatorelektroden CEU1-CEU3 erfolgen gemäß bekannter Halbleiterprozeßtechnologie.

Das großflächige Abscheiden einer Schicht 70 aus dem ferroelektrischen Material SBT über den unteren Kondensatorelektroden CEU1-CEU3 und der Isolatorschicht 50 sowie das großflächige Abscheiden einer Schicht aus dem Material der oberen Kondensatorelektrode CEO, hier Pt, auf der Schicht aus dem ferroelektrischen Material und das Freilegen der Peripherie und zweckmäßige Kapseln des Zellenfeldes durch eine weitere Isolatorschicht schließen die wesentlichen Prozeßschritte zur Herstellung des in Fig. 1 bis 3 illustrierten Zellenfeldes gemäß der Ausführungsform der erfindungsgemäßen Speicherzellenanordnung ab.

Weitere mögliche Prozeßschritte beinhalten das übliche Back End mit Abscheidung eines Zwischenschicht-Dielektrikums mit Planarisierung, Einbringen von Kontakten und einer oder mehreren Metallisierungsebenen. Der Gesamtprozeß wird üblicherweise abgeschlossen mit einer Endpassivierung und einem Photoimidschritt.

Obwohl die vorliegende Erfindung vorstehend anhand bevorzugter Ausführungsbeispiele beschrieben wurde, ist sie darauf nicht beschränkt, sondern auf vielfältige Art und Weise modifizierbar.

Insbesondere sind die angegebenen Grundmaterialien und Zusatzmaterialien nur beispielhaft und können durch geeignete andere Materialien ersetzt werden.

Folgende sonstige ferroelektische Materialien sind u.a. verwendbar: Blei-Zirkon-Titanat, Bariumtitanat, Blei-Lanthan-Titanat, Strontium-Wismut-Tantalat, Wismuttitanat.

Auch ist das Kondensator-Dielektrikum nicht auf Ferroelektrika beschränkt, sondern durch andere geeignete Dielektrika, z.B. die paraelektrischen Materialien Barium-Strontium-Titanat, Strontiumtitanat Barium-Zirkon-Titanat, ersetzbar.

## Patentansprüche

1. Speicherzellenanordnung mit einer Vielzahl von in einem Halbleitersubstrat (10) vorgesehenen vorzugsweise ferroelektrischen Speicherzellen (S) mit:
in Längsrichtung in der Hauptfläche des Halbleitersubstrats (10) parallel verlaufenden Bitleitungsgräben (1a-1e), in deren Böden jeweils eine Bitleitung (15a-15d) vorgesehen ist, in deren Kronen jeweils ein Source/Drain-Gebiet (25a-25d) vorgesehen ist und in deren Wänden jeweils ein Kanalgebiet (17a-17d; 20a-20d) vorgesehen ist;
wobei jeweils das Kanalgebiet (17a-17d) an einer Wand derart gestaltet ist, daß dort ein ansteuerbarer Auswahltransistor der betreffenden Speicherzelle (S) mit einer bestimmten Einsatzspannung gebildet ist, während das Kanalgebiet (20a-20d) an der anderen Wand derart gestaltet ist, daß der dortige Transistor bei der Einsatzspannung geschlossen ist;
in Querrichtung entlang der Hauptfläche des Halbleitersubstrats (10) durch die Bitleitungsgräben (1a-1e) verlaufenden isolierten Wortleitungen (2a-2d) zur Ansteuerung der Auswahltransistoren;
in Querrichtung in der Hauptfläche des Halbleitersubstrats (10) verlaufenden Isolationsgräben (3a-3c) zur Isolation der Source/Drain-Gebiete in Längsrichtung benachbarter Speicherzellen (S); und
jeweils einem mit dem Source/Drain-Gebiet (25b, 26b, 27b) der betreffenden Speicherzelle (S) verbundenen, oberhalb der Wortleitungen (2a-2d) angeordneten vorzugsweise ferroelektrischen Kondensator (CEU1-CEU3; CEO; 70).

2. Speicherzellenanordnung nach Anspruch 1, **dadurch gekennzeichnet, daß** das jeweilige Kanalgebiet (20a-20d) an der anderen Wand geschlossen ist und das jeweilige Kanalgebiet (17a-17d) an der einen Wand offen ist.

3. Speicherzellenanordnung nach Anspruch 1 oder 2, **dadurch gekennzeichnet, daß** zwischen den Source/Drain-Gebieten (25a-25d) und den Kanalgebieten (17a-17d; 20a-20d) einerseits und der jeweiligen Wortleitung (2a-2d) andererseits eine Oxidschicht vorgesehen ist.

4. Speicherzellenanordnung nach einem der vorhergehenden Ansprüche, **dadurch gekennzeichnet, daß** die Wortleitungen (2a-2d) seitlich isolierende Spacer aus Siliziumoxid oder Siliziumnitrid aufweisen.

5. Speicherzellenanordnung nach einem der vorhergehenden Ansprüche, **dadurch gekennzeichnet, daß** die Wortleitungen (2a-2d) an ihrer Oberseite einen isolierenden Spacer aus Siliziumoxid oder Siliziumnitrid aufweisen.

6. Speicherzellenanordnung nach einem der vorhergehenden Ansprüche, **dadurch gekennzeichnet, daß** die Wortleitungen (2a-2d) vollständig in eine Isolatorschicht (50), die vorzugsweise Phosphorsilikatglas aufweist, eingebettet sind.

7. Speicherzellenanordnung nach Anspruch 6, **dadurch gekennzeichnet, daß** durch die Isolatorschicht (50) Kontaktstöpsel (55a-55c) geführt sind, welche jeweils einen Kontakt zu einem Source/Drain-Gebiet (25b, 26b, 27b) eines Auswahltransistors einer betreffenden Speicherzelle bilden.

8. Speicherzellenanordnung nach Anspruch 7, **dadurch gekennzeichnet, daß** die Kontaktstöpsel (55a-55c) auf den Kronen der Bitleitungsgräben (1a-1e) im Bereich zwischen den Isolationsgräben (3a-3d) und den Wortleitungen (2a-2d) vorgesehen sind.

9. Speicherzellenanordnung nach Anspruch 8, **dadurch gekennzeichnet, daß** in Verbindung mit dem jeweiligen Kontaktstöpsel (55a-55c) auf der Isolatorschicht (50) eine entsprechende untere Kondensatorelektrode (CEU1-CEU3) vorzugsweise mit einer zwischengesetzten Barrierenschicht vorgesehen ist.

10. Speicherzellenanordnung nach Anspruch 9, **dadurch gekennzeichnet, daß** über den unteren Kondensatorelektroden (CEU1-CEU3) und der dazwischenliegenden Isolatorschicht (50) großflächig eine Schicht (70) aus einem Ferroelektrikum, vorzugsweise aus Strontium-Wismut-Tantalat, vorgesehen ist.

11. Speicherzellenanordnung nach Anspruch 10, **dadurch gekennzeichnet, daß** über der Schicht (70) aus einem Ferroelektrikum großflächig eine gemeinsame obere Kondensatorelektrode (CEO) vorgesehen ist.

12. Speicherzellenanordnung nach einem der vorhergehenden Ansprüche, **dadurch gekennzeichnet, daß** die Gräben der Bitleitungen (1a-1e), die Kronen der Bitleitungen (1a-1e), die Wortleitungen (2a-2d) und die Isolationsgräben (3a-3d) jeweils eine minimale Strukturbreite F aufweisen, der Bereich zwischen zwei Isolationsgräben (3a-3d) 2F beträgt und jede Speicherzelle einen Bereich von 6F² einnimmt.

13. Speicherzellenanordnung nach Anspruch 12, **dadurch gekennzeichnet, daß** die jeweilige untere Kondensatorplatte (CEU1-CEU3) einen Bereich von 2F² einnimmt.

14. Speicherzellenanordnung nach Anspruch 13, **dadurch gekennzeichnet, daß** die jeweilige untere Kondensatorplatte (CEU1-CEU3) in Querrichtung im Bereich zwischen zwei benachbarten Bitleitungsgräben (1a, 1b) und in Längsrichtung im Bereich zwischen einer Wortleitung (2a) und einem benachbarten Isolationsgraben (3b) und die Wortleitung (2a) und den Isolationsgraben (3b) jeweils zur Hälfte überdeckend vorgesehen ist.

15. Verfahren zur Herstellung einer Speicherzellenanordnung mit vorzugsweise ferroelektrischen Speicherzellen nach mindestens einem der vorhergehenden Ansprüche mit den Schritten:
Bereitstellen des Halbleitersubstrats (10);
Bilden der Isolationsgräben (3a-3c) in der Hauptfläche des Halbleitersubstrats (10) vorzugsweise in STI-Technik;
Bilden der Bitleitungsgräben (1a-1e) in der Hauptfläche des Halbleitersubstrats (10);
Bilden der Bitleitungen (15a-15d) und der Source/Drain-Gebiete (25a-25d) vorzugsweise durch gleichzeitige Implantation oder Diffusion;
Bilden der Auswahltransistoren durch Ändern der Dotierung einer der jeweiligen beiden Wände der Bitleitungsgräben (1a-1e) und Abscheiden des Gateisolators; und
Bilden der Wortleitungen und der vorzugsweise ferroelektrischen Kondensatoren (CEU1-CEU3; CEO; 70).

16. Verfahren nach Anspruch 15, **dadurch gekennzeichnet, daß** das Bilden der Wortleitungen (2a-2d) folgende Schritte umfaßt:
großflächiges Abscheiden einer Schicht aus Wortleitungsmaterial, vorzugsweise Polysilizium;
Bilden einer Hartmaske vorzugsweise aus Oxid entsprechend der Wortleitungsstruktur; und
Ätzen der Wortleitungen (2a-2d) mit der Hartmaske.

17. Verfahren nach Anspruch 16, **dadurch gekennzeichnet, daß** das Bilden der Wortleitungen (2a-2d) weiterhin folgende Schritte umfaßt:
Belassen der Hartmaske auf der Oberseite der Wortleitungen als oberen isolierenden Spacer; und
Bilden seitlicher isolierender Spacer (30) vorzugsweise aus Siliziumoxid oder Siliziumnitrid.

18. Verfahren nach einem der Ansprüche 15 bis 17, **gekennzeichnet durch** die Schritte:
Abscheiden und Planarisieren einer Isolatorschicht (50), die vorzugsweise aus dotiertem Silikatglas oder aus einer Doppelschicht aus undotiertem Oxid oder undotiertem Nitrid mit einem dotierten Silikatglas besteht;
Bilden von Durchgangslöchern in der Isolatorschicht (50) zur Kontaktierung der Source/Drain-Gebiete; und
Abscheiden einer Schicht aus dem Kontaktstöpselmaterial und Rückätzen der Schicht bis zur Isolatorschicht (50).

19. Verfahren nach Anspruch 18, **gekennzeichnet durch** die Schritte:
Abscheiden einer leitenden Barrierenschicht (60) vorzugsweise aus TiN auf der Isolatorschicht (50) mit den Kontaktstöpseln (55a-55c);
Abscheiden einer Schicht aus dem Material der unteren Kondensatorelektroden (CEU1-CEU3) vorzugsweise aus Pt auf der leitenden Barrierenschicht (60);
Strukturieren der leitenden Barrierenschicht (60) und der Schicht aus dem Material der unteren Kondensatorelektroden (CEU1-CEU3) zum Bilden der unteren Kondensatorelektroden (CEU1-CEU3).

20. Verfahren nach Anspruch 19, **gekennzeichnet durch** die Schritte:
großflächiges Abscheiden einer Schicht (70) aus einem ferroelektrischen Material über den unteren Kondensatorelektroden (CEU1-CEU3) und der Isolatorschicht (50);
großflächiges Abscheiden einer Schicht aus dem Material der oberen Kondensatorelektrode (CEO) vorzugsweise aus Pt auf der Schicht (70) aus einem ferroelektrischen Material; und
Freilegen der Peripherie und vorzugsweise Kapseln des Zellenfeldes **durch** eine weitere Isolatorschicht.

## Claims

1. Memory cell arrangement having a multiplicity of preferably ferroelectric memory cells (S) provided in a semiconductor substrate (10), having:
bit line trenches (1a-1e) running parallel in the longitudinal direction in the main area of the semiconductor substrate (10), in the bottoms of which trenches a respective bit line (15a-15d) is provided, in the crowns of which trenches a respective source/drain region (25a-25d) is provided, and in the walls of which trenches a respective channel region (17a-17d; 20a-20d) is provided;
the channel region (17a-17d) on a wall in each case being configured in such a way that a drivable selection transistor of the relevant memory cell (S) is formed there with a given threshold voltage, while the channel region (20a-20d) on the other wall is configured in such a way that the transistor located there is closed at the threshold voltage;
insulated word lines (2a-2d) for driving the selection transistors, which word lines run in the transverse direction along the main area of the semiconductor substrate (10) through the bit line trenches (1a-1e) ;
insulation trenches (3a-3c) for insulating the source/drain regions in the longitudinal direction of neighbouring memory cells (S), which insulation trenches run in the transverse direction in the main area of the semiconductor substrate (10); and
a respective, preferably ferroelectric capacitor (CEU1-CEU3; CEO; 70), which is connected to the source/drain region (25b, 26b, 27b) of the relevant memory cell (S) and is arranged above the word lines (2a-2d).

2. Memory cell arrangement according to Claim 1, **characterized in that** the respective channel region (20a-20d) on the other wall is closed and the respective channel region (17a-17d) on said one wall is open.

3. Memory cell arrangement according to Claim 1 or 2, **characterized in that** an oxide layer is provided between the source/drain regions (25a-25d) and the channel regions (17a-17d; 20a-20d), on the one hand, and the respective word line (2a-2d) on the other hand.

4. Memory cell arrangement according to one of the preceding claims, **characterized in that** the word lines (2a-2d) have laterally insulating spacers made of silicon oxide or silicon nitride.

5. Memory cell arrangement according to one of the preceding claims, **characterized in that** the word lines (2a-2d) have an insulating spacer made of silicon oxide or silicon nitride on their top side.

6. Memory cell arrangement according to one of the preceding claims, **characterized in that** the word lines (2a-2d) are completely embedded in an insulator layer (50), which preferably has phosphosilicate glass.

7. Memory cell arrangement according to Claim 6, **characterized in that** contact plugs (55a-55c) are passed through the insulator layer (50), which plugs each form contact with a source/drain region (25b, 26b, 27b) of a selection transistor of a relevant memory cell.

8. Memory cell arrangement according to Claim 7, **characterized in that** the contact plugs (55a-55c) are provided on the crowns of the bit line trenches (1a-1e) in the zone between the insulation trenches (3a-3d) and the word lines (2a-2d).

9. Memory cell arrangement according to Claim 8, **characterized in that** a corresponding lower capacitor electrode (CEU1-CEU3) is provided, preferably with an interposed barrier layer, in conjunction with the respective contact plug (55a-55c) on the insulator layer (50).

10. Memory cell arrangement according to Claim 9, **characterized in that** a layer (70) made of a ferroelectric, preferably made of strontium bismuth tantalate, is provided in a large-area manner over the lower capacitor electrodes (CEU1-CEU3) and the insulator layer (50) situated inbetween.

11. Memory cell arrangement according to Claim 10, **characterized in that** a common upper capacitor electrode (CEO) is provided in a large-area manner over the layer (70) made of a ferroelectric.

12. Memory cell arrangement according to one of the preceding claims, **characterized in that** the trenches of the bit lines (1a-1e), the crowns of the bit lines (1a-1e), the word lines (2a-2d) and the insulation trenches (3a-3d) each have a minimal structure width F, the zone between two insulation trenches (3a-3d) amounts to 2 F and each memory cell occupies a zone of 6 F².

13. Memory cell arrangement according to Claim 12, **characterized in that** the respective lower capacitor plate (CEU1-CEU3) occupies a zone of 2 F².

14. Memory cell arrangement according to Claim 13, **characterized in that** the respective lower capacitor plate (CEU1-CEU3) is provided in the transverse direction in the zone between two neighbouring bit line trenches (1a, 1b) and in the longitudinal direction in the zone between a word line (2a) and a neighbouring insulation trench (3b) and in a manner such that it covers in each case half of the word line (2a) and of the insulation trench (3b).

15. Method for fabricating a memory cell arrangement having preferably ferroelectric memory cells according to at least one of the preceding claims, having the following steps:
provision of the semiconductor substrate (10);
formation of the insulation trenches (3a-3c) in the main area of the semiconductor substrate (10) preferably using STI technology;
formation of the bit line trenches (1a-1e) in the main area of the semiconductor substrate (10);
formation of the bit lines (15a-15d) and of the source/drain regions (25a-25d) preferably by simultaneous implantation or diffusion;
formation of the selection transistors by changing the doping of one of the respective two walls of the bit line trenches (1a-1e) and deposition of the gate insulator; and
formation of the word lines and of the preferably ferroelectric capacitors (CEU1-CEU3; CEO; 70).

16. Method according to Claim 15, **characterized in that** the formation of the word lines (2a-2d) comprises the following steps:
large-area deposition of a layer made of word line material, preferably polysilicon;
formation of a hard mask preferably made of oxide in a manner corresponding to the word line structure; and
etching of the word lines (2a-2d) using the hard mask.

17. Method according to Claim 16, **characterized in that** the formation of the word lines (2a-2d) furthermore comprises the following steps:
leaving of the hard mask on the top side of the word lines as upper insulating spacer; and
formation of lateral insulating spacers (30) preferably made of silicon oxide or silicon nitride.

18. Method according to one of Claims 15 to 17, **characterized by** the following steps:
deposition and planarization of an insulator layer (50) preferably composed of doped silicate glass or of a double layer made of undoped oxide or undoped nitride with a doped silicate glass;
formation of through holes in the insulator layer (50) for the purpose of making contact with the source/drain regions; and
deposition of a layer made of the contact plug material and etching back of the layer as far as the insulator layer (50).

19. Method according to Claim 18, **characterized by** the following steps:
deposition of a conductive barrier layer (60) preferably made of TiN on the insulator layer (50) with the contact plugs (55a-55c);
deposition of a layer made of the material of the lower capacitor electrodes (CEU1-CEU3) preferably made of Pt on the conductive barrier layer (60);
structuring of the conductive barrier layer (60) and of the layer made of the material of the lower capacitor electrodes (CEU1-CEU3) for the purpose of forming the lower capacitor electrodes (CEU1-CEU3).

20. Method according to Claim 19, **characterized by** the following steps:
large-area deposition of a layer (70) made of a ferroelectric material over the lower capacitor electrodes (CEU1-CEU3) and the insulator layer (50);
large-area deposition of a layer made of the material of the upper capacitor electrode (CEO) preferably made of Pt on the layer (70) made of a ferroelectric material; and
uncovering of the periphery and preferably encapsulation of the cell array by a further insulator layer.

## Revendications

1. Dispositif à cellules de mémoire comportant une multiplicité de cellules de mémoire de préférence ferroélectriques (S), prévues dans un substrat semiconducteur (10), comportant
des sillons (1a-1e) pour les lignes de bits, qui s'étendent parallèlement à la surface principale du substrat semiconducteur 10) et dans les fonds desquels est prévue respectivement une ligne de bits (15a-15d), et aux sommets desquels est prévue respectivement une région source/drain (25a-25d) et dans les parois desquels est prévue respectivement une région de canal (17a-17d; 20a-20d);
dans lequel respectivement la région de canal (17a-17d) est formée dans une paroi de telle sorte qu'un transistor de sélection commandable de la cellule de mémoire considérée (S) est formé par une tension, d'utilisation déterminée, tandis que la région de canal (20a-20d) est formée sur l'autre paroi de telle sorte que le transistor présent en cet endroit est bloqué, pour la tension d'utilisation;
des lignes de mots isolées (2a-2d) servant à commander les transistors de sélection et qui s'étendent dans la direction transversale le long de la surface principale du substrat semiconducteur (10) à travers les sillons (la-le) des lignes de bits;
des sillons isolants (3a-3c), qui s'étendent dans la direction transversale dans la surface principale du substrat semiconducteur (10), pour isoler des régions source-drain dans la direction longitudinale de cellules de mémoire voisines (S); et
respectivement un condensateur de préférence ferroélectrique (CEU1-CEU3; CEO; 70), qui est relié à la région source/drain (25b,26b,27b) de la cellule de mémoire concernée (S), et est disposé au-dessus des lignes de mots (2a-2d).

2. Dispositif à cellules de mémoire selon la revendication 1, **caractérisé en ce que** la région de canal respective (20a-20d) est raccordée à l'autre paroi et la région de canal respective (17a-17d) est ouverte au niveau d'une paroi.

3. Dispositif à cellules de mémoire selon la revendication 1 ou 2, **caractérisé en ce qu'**une couche d'oxyde est prévue entre les régions de source/drain (25a-25d) et les régions de canal (17a-17d; 20a-20d) d'une part et la ligne de mots respective (2a-2d) d'autre part.

4. Dispositif à cellules de mémoire selon l'une des revendications précédentes, **caractérisé en ce que** les lignes de mots (2a-2d) possèdent latéralement des espaceurs isolants formés d'oxyde de silicium ou de nitrure de silicium.

5. Dispositif à cellules de mémoire selon l'une des revendications précédentes, **caractérisé en ce que** les lignes de mots (2a-2d) possèdent, sur leur côté supérieur, un espaceur isolant formé d'oxyde de silicium ou de nitrure de silicium.

6. Dispositif à cellules de mémoire selon l'une des revendications précédentes, **caractérisé en ce que** les lignes de mots (2a-2d) sont complètement insérées dans une couche isolante (50), qui comporte de préférence du verre aux phosphosilicates.

7. Dispositif à cellules de mémoire selon la revendication 6, **caractérisé en ce que** des fiches de contact (55a-55c), qui forment chacune un contact avec une région de source/drain (25b,26b,27b) d'un transistor de sélection de cellules de mémoire considérées, traversent la couche isolante (50).

8. Dispositif à cellules de mémoire selon la revendication 7, **caractérisé en ce que** les tiges de contact (55a-55c) sont prévues sur les sommets des sillons (1a-1d) des lignes de bits dans la zone comprise entre les sillons isolants (3a-3d) et les lignes de mots (2a-2d).

9. Dispositif à cellules de mémoire selon la revendication 8, **caractérisé en ce qu'**en liaison avec la tige de contact respective (55a-55c), il est prévu, sur la couche isolante (50), une électrode inférieure correspondante de condensateur (CEU1-CEU3), comportant de préférence une couche formant barrière intercalée.

10. Dispositif à cellules de mémoire selon la revendication 9, **caractérisé en ce qu'**une couche (70) formée d'un matériau ferroélectrique, de préférence du tantalate de strontium et de bismuth, est prévue sur une surface étendue au-dessus des électrodes inférieures de condensateur (CEU1-CEU3) et de la couche isolante intercalaire (50).

11. Dispositif à cellules de mémoire selon la revendication 10, **caractérisé en ce qu'**une électrode supérieure de condensateur commune (CEO) est prévue sur une surface étendue au-dessus de la couche 70 formée d'un matériau ferroélectrique.

12. Dispositif à cellules de mémoire selon l'une des revendications précédentes, **caractérisé en ce que** les sillons signaux des lignes de bits (1a-1e), les sommets des lignes de bits (1a-1e), les lignes de mots (2a-2d) et les sillons isolants (3a-3d) possèdent respectivement une largeur de structure minimale (F), que la zone entre deux sillons isolants (3a-3d) est égale à 2F et que chaque cellule de mémoire occupe une zone égale à 6F².

13. Dispositif à cellules de mémoire selon la revendication 12, **caractérisé en ce que** la plaque inférieure respective de condensateur (CEU1-CEU3) occupe une zone égale à 2F².

14. Dispositif à cellules de mémoire selon la revendication 13, **caractérisé en ce que** la plaque inférieure respective du condensateur (CEU1-CEU3) est prévue dans la direction transversale dans la zone entre deux sillons voisins de lignes de bits (1a,1b) et dans la direction longitudinale dans la zone entre une ligne de mots (2a) et un sillon d'isolation voisin (3b) et la ligne de mots (2a) et un sillon isolant voisin (3b) et la ligne est prévue de manière à recouvrir respectivement de moitié la ligne de mots (2a) et le sillon isolant (3b).

15. Procédé pour fabriquer un dispositif à cellules de mémoire comportant des cellules de mémoire de préférence ferroélectriques selon au moins l'une des revendications précédentes, comprenant les étapes consistant à :
préparer le substrat semiconducteur (10);
former les sillons isolants (3a-3c) dans la surface principale du substrat semiconducteur (10) de préférence selon la technique STI;
former les sillons (1a-1e) des lignes de bits dans la surface principale du substrat semiconducteur (10);
former les lignes de bits (15a-15d) et des régions source/ drain (25a-25d) de préférence par implantation ou diffusion simultanée;
former les transistors de sélection par modification du dopage de l'une des deux parois respectives des sillons de lignes de bits (1a-1e) et sectionner l'isolant de grille; et
former les lignes de mots et les condensateurs de préférence ferroélectriques (CEU1-CEU3; CEO; 70).

16. Procédé selon la revendication 15, **caractérisé en ce que** la formation des conducteurs de mots (2a-2d) comprend les étapes consistant à :
déposer sur une surface étendue une couche d'un matériau pour lignes de mots, de préférence du polysilicium;
former un masque dur de préférence en oxyde conformément à la structure des lignes de mots;
graver les lignes de mots (2a-2d) en utilisant le masque dur.

17. Procédé selon la revendication 16, **caractérisé en ce que** la formation des lignes de mots (2a-2d) comprend en outre les étapes suivantes consistant à :
laisser en place le masque dur sur la face supérieure des lignes de mots, en tant qu'espaceur supérieur isolant; et
former des espaceurs latéraux isolants (30) de préférence en oxyde de silicium ou en nitrure de silicium.

18. Procédé selon l'une des revendications 15 à 17, **caractérisé par** les étapes consistant à :
déposer et planariser une couche isolante (50), qui est constituée de préférence par du verre à base de silicate dopé ou par une couche double d'oxyde non dopé ou de nitrure non dopé comportant un verre à base de silicate dopé; former des trous traversants dans la couche isolante (50) pour établir un contact avec les régions de source/drain; et
déposer une couche formée du matériau pour fiches de contact et effectuer une gravure en retrait de la couche jusqu'à la couche isolante (50).

19. Procédé selon la revendication 18, **caractérisé par** les étapes consistant à :
déposer une couche formant barrière conductrice (60) de préférence en TiN sur la couche isolante (50) avec les fiches de contact (55a-55c) ;
déposer une couche formée du matériau des électrodes inférieures de condensateurs (CEU1-CEU3) de préférence en Pt sur la couche formant barrière isolante (60);
structurer la couche formant barrière conductrice (60) et la couche formée du matériau des électrodes inférieures des condensateurs (CEU1-CEU3) pour former les électrodes inférieures (CEU1-CEU3) des condensateurs.

20. Procédé selon la revendication 19, **caractérisé par** les étapes consistant à :
déposer sur une surface étendue une couche (70) formée d'un matériau ferroélectrique au-dessus des électrodes inférieures (CEU1-CEU3) des condensateurs et de la couche isolante (50);
déposer sur une surface étendue une couche formée du matériau de l'électrode supérieure (CEO) du condensateur, de préférence en Pt, sur la couche (70) formée d'un matériau ferroélectrique; et
dégager la périphérie et de préférence encapsuler le champ des cellules par une autre couche isolante.
